# EUROPEAN PATENT SPECIFICATION

(11) **EP 1 380 439 B1**
(45) Date of publication and mention of the grant of the patent: **03.05.2006**
(21) Application number: 02425455.9
(22) Date of filing: 10.07.2002
(51) Int. Cl.: B41M 5/36, B41C 1/10

(54) **Heat-sensitive composition, negative working lithographic printin plate precursor coated with the said composition and method for forming a negative image on the said plate**
Wärmeempfindliche Zusammensetzung, negativ arbeitender lithographischer Druckplattenvorläufer beschichtet mit dieser Zusammensetzung und Verfahren zur Herstellung eines negativen Bildes auf dieser Platte
Composition thermosensible, précurseur de plaque d'impression lithographique de type négatif enduite avec cette composition et procédé de fabrication d'images négatives sur cette plaque

(43) Date of publication of application: 14.01.2004
(73) Proprietor: LASTRA S.P.A., I-25025 Manerbio (IT)
(72) Inventor: Bolli, Angelo, 25025 Manerbio (Brescia) (IT); Tettamanti, Andrea, 27040 Mornico Losana (Pavia) (IT)
(74) Representative: Goedeweeck, Rudi

(56) References cited:
- EP-A- 0 911 153
- EP-A- 0 913 253
- EP-A- 1 029 668
- EP-A- 1 170 123

## Description

### FIELD OF THE INVENTION

This invention relates to a heat-sensitive composition in which removal of the unexposed regions is unnecessary, a negative lithographic plate coated with the said composition and a method for forming a negative image on the said plate.

In particular it relates to a heat-sensitive composition which during exposure to heat does not involve the ablation of exposed regions by vaporization and which after the stage of exposure to heat does not involve removal of the unexposed regions with a developer bath, thus making it possible to proceed directly from the exposure stage to the printing stage.

Even more particularly, this invention relates to a composition in which the image-forming stage requires low energy and in which the affinity of the unexposed regions for water and the affinity of the exposed regions for ink are both optimal.

### BACKGROUND TO THE INVENTION

As is known, the technique of printing using lithographic plates is based on a difference in distribution between fatty substances and water. The fatty substance, or ink, is retained by the image area and water is retained by the non-image area. When the surface of a suitably prepared lithographic plate is moistened with water and then sprayed with ink, the non-image area retains the water and rejects the ink, while the image area accepts the ink and rejects the water. The ink is then transferred from the image area to the surface of a material on which it is desired to reproduce the image, such as for example paper, fabric and the like.

In general the lithographic plates used in printing processes are made from an aluminium substrate coated with a composition which is sensitive to light radiation and/or heat.

In plates of the conventional type the stage of exposure to light radiation and/or heat is followed by a stage of developing in an aqueous alkaline bath. When the portion of the exposed composition is soluble in the developer bath, the printing process is known as "positive". Conversely, when the exposed portion is insoluble, the printing process is known as "negative". In both cases the remaining image area is lipophilic and therefore accepts the ink, while the non-image area is hydrophilic and accepts the water.

EP-A-0 911 153 discloses an image forming method comprising the steps of imagewise heating or imagewise exposing to a laser with a wavelength of 700 to 1200 nm an image forming material; and continuously developing the exposed or heated material with a developer, while the developer is replenished with a developer replenisher, wherein the image forming material comprises a support and provided thereon, a radiation sensitive layer containing a dye having an absorption band in the wavelength region of from 700 nm to 1200 nm, an acid generating compound capable of generating an acid on irradiation of heat or actinic light, and an acid decomposable compound having a bond capable of being decomposed by an acid. The layer further comprises a compound capable of being insolubilized in an alkali by an acid (or acid insolubilizing compound) and a binder able to change their solubility from alkali soluble to alkali insoluble under exposure to heat or laser light. This document does not mention any compound capable of changing its affinity towards hydrophilic or lipophilic materials, or imaging materials not requiring removal of material or post-treatment in alkaline developing baths in order to form the image.

EP-A-0 924 065 describes a heat-sensitive member forming an image without the ablation of material for a lithographic plate having as an upper layer on a substrate an image-forming layer comprising a binder which is switchable to heat, characterised in that the said image-forming layer becomes hydrophobic under the influence of heat, the said binder which is switchable to heat having attached hydrophilic groups and being a (co)polymer containing monomer units selected from the group comprising malic acid, itaconic acid, 3- or 4-vinylphthalic acid, cis-1,2,3,6-tetrahydrophthalic acid cis-norbene-endo-2,3-dicarboxylic acid and their hemiesters.

The heat required to form the image is provided by IR radiation and preferably the image-forming coating also contains a dye (absorber) which is capable of absorbing IR radiation and converting it at least partly into heat.

The plate in EP-A-0 924 065 has the advantage that it does not require any developing treatment after the stage of exposure to heat. In addition to this the equipment used to expose this plate to heat does not require those special systems for the collection of removed wastes which are required in the case of ablation plates, where the image is formed by removing the parts of the coating which have been exposed to heat.

This does however have the disadvantage that it requires the application of high energy in order to form the image. In fact Examples 1 and 2 in EP-A-0 924 065 indicate that in order to form an image using a laser with a power of 11 watts the drum must rotate at a speed of 40 rpm. This is equivalent to energy of approximately 710 mJoule/cm². In addition to the expenditure of energy, this means that the machine must be used at low speed, with consequent low productivity.

This makes such a plate unacceptable for the graphic arts industry.

In addition to this, experiments which have been performed by the Applicant have demonstrated that a lithographic plate coated with the composition described in Example 1 of the aforesaid patent has some affinity for ink even in the regions which have not been exposed. It follows that the images printed do not have white backgrounds (Comparison Example 1).

Another disadvantage of the aforesaid composition is that the heat-switchable binder which it contains is not stable over time. In fact in addition to incorporating a number of attached carboxyl groups, the said binder also comprises a certain percentage of maleic anhydride rings, and the latter tend to open over time, thus changing the properties of the heat-switchable binder.

The said heat-switchable binder is stable over time only when all the malic anhydride rings have been opened to form attached carboxyl groups. The Applicant has therefore tested a composition similar to that described in Example 1 in the aforesaid patent, but using a heat-switchable binder in which the malic anhydride rings have been opened by acid hydrolysis. This plate did not however form an image which had an affinity for ink.

In the graphic arts industry there is therefore still a greatly felt need for a negative lithographic plate which does not have the disadvantages of the plate in EP-A-0 924 065.

### OBJECTS OF THE INVENTION

A first object of this invention is to provide a heat-sensitive composition, the composition being such that the image-forming stage requires low energy, forms an image without the removal of material and requires no developing treatment after the stage of exposure to IR radiation.

A second object is that the said composition should form an image having an optimum affinity for water in the regions which have not been exposed to heat.

A third object of this invention is a negative lithographic plate comprising a coating which in turn comprises the aforesaid composition.

A fourth object of this invention is a method for forming a negative image whose affinity for water in the unexposed regions and for ink in the exposed regions are both optimal, the said negative image being obtained in a coating on a substrate which comprises a switchable composition, forms an image without the removal of material and does not require any development treatment after the heat exposure stage, the said method comprising a stage of exposure of the said coating to heat which involves the application of a small quantity of energy.

### DEFINITIONS

In this description and in the claims the following terms have the meanings indicated below.

By the term "lithographic plate" is meant a substrate covered with a sensitive coating which through exposure to light radiation and/or heat forms lipophilic image regions and hydrophilic non-image regions such that the said substrate can be used as a planographic matrix in printing processes which are based on a difference in distribution between fatty substances and water. Conventional lithographic plates also require a developing stage after exposure in order to remove the coating from the non-image regions using an aqueous alkaline developer bath. Typical examples of substrate materials are aluminium, zinc and copper, polymer substrates such as polyesters, and polymer-coated paper. Even more typically the substrate is a metal sheet, preferably aluminium. The surface of the sheet on which the coating which is sensitive to light radiation and/or heat is spread may be electrochemically grained, subjected to anodic oxidation and appropriately pretreated.

By the term "the negative type" is meant that the lipophilic image forms in the regions of the sensitive coating which have been exposed to light radiation and/or heat.

By the term "fount solution" is meant an aqueous solution comprising water (80-95%), isopropyl alcohol (5-20%) and a pH stabilising agent (2-5%). As is known to those skilled in the art, isopropyl alcohol can be replaced or accompanied by other organic substances capable of reducing or preventing mixing between ink and water such as for example ethylene glycol monobutylether, ethylene glycol mono t-butyl ether, propylene glycol monopropyl ether, propylene glycol monobutyl ether and the like.

By the term "no-process" is meant a composition which does not require a stage of developing between the stages of exposure and printing.

The term "switchable", when relating to a compound or a composition, indicates that that compound or composition is able to reverse its affinity to one of the substances used in printing (water and fatty substances) following exposure to light radiation or heat. For example a hydrophilic composition which becomes lipophilic after being exposed to light radiation and/or heat is regarded as being switchable.

The term "IR radiation" is used to indicate radiation of a wavelength between 650 nm and 1300 nm. A typical example of a device used to generate IR radiation is a laser diode which emits at approximately 830 nm.

The terms "high energy" and "large quantity of energy" indicate an energy ≥ 350 mJoule/cm².

The terms "low energy" and "small quantity of energy" indicate an energy ≤ 250 mJoule/cm².

By the term "IR absorber" is meant a compound capable of absorbing IR radiation, of converting at least part of the absorbed radiation into heat and of giving this up to the immediately adjacent environment. Typical examples of IR absorbers are carbon black and many organic dyes, especially cyanine dies.

The term "heat" indicates the heat delivered from a thermal head or from IR radiation in the presence of an IR absorber

By the term "novolak resin" is meant a polymer obtained by the reaction between formaldehyde and phenol in a molar ratio of less than 1, for example formaldehyde:phenol =1:2, with acid catalysis. The phenol is preferably selected from the group comprising phenol, m-cresol, p-cresol, symmetrical xylenol and their mixtures.

By the term "triazine compound", is meant a compound obtained by the condensation of formaldehyde with an aminotriazine and subsequent reaction of the product so obtained with an aliphatic alcohol having 1-4 C atoms.

### SUMMARY OF THE INVENTION

The Applicant has found that all the objects of the invention are achieved by a composition comprising (a) a switchable polymer, (b) and IR absorber, (c) a triazine compound, and (d) a novolak resin.

Surprisingly this composition has an optimum affinity for water before being exposed to heat and manifests an optimum affinity for ink after being exposed to heat.

What is also surprising is that the quantity of energy required to obtain the change in affinity is small.

### DETAILED DESCRIPTION OF THE INVENTION

In a first aspect this invention relates to a heat-sensitive composition which forms an image without the removal of material, requires no developing treatment after the stage of exposure to heat and comprises:
a) a switchable polymer, and
b) an IR absorber,
characterised in that it also comprises:
c) a triazine compound, and
d) a novolak resin.

Preferably the said polymer has attached hydrophilic groups and becomes lipophilic through the effect of IR radiation.

Advantageously the said attached hydrophilic groups are carboxyl groups.

in a preferred embodiment the said switchable polymer is a (co)polymer containing monomer units selected from the group comprising malic acid, itaconic acid, 3- or 4-vinylphthalic acid, cis-1,2,3,6-tetrahydrophthalic acid, cis-norbene-endo-2,3-dicarboxylic acid and their hemiesters.

In a further preferred embodiment the said switchable polymer is obtained by the acid hydrolysis of a methyl vinyl ether copolymer and maleic anhydride, the said hydrolysis being performed in such a way as to open up the maleic anhydride rings to give each a pair of adjacent attached carboxyl groups. Advantageously, this acid hydrolysis is performed in such a way as to open all the rings in the anhydride.

Preferably the weight-average molecular weight of the switchable (co)polymer according to this invention is between 100,000 and 2,000,000.

Typical examples of switchable commercial polymers according to this invention are those obtained by the acid hydrolysis of methyl vinyl ether copolymer/maleic anhydride like the Gantrez™ products from the company ISP Chemicals which are identified by the trade names:
S 95 BF (weight average molecular weight = 200,000 - 300,000),
S 96 BF (weight average molecular weight = 700,000 - 800,000), and
S 97 BF (weight average molecular weight = 1,500,000 - 1,900,000).

Preferably the quantity of the said switchable polymer in the composition according to the invention is between 50% and 75% by weight. Even more preferably the said quantity is between 55% and 70% by weight.

The type of IR absorber used in the composition according to the invention is not critical. It may for example be carbon black or one of the many organic dyes known for their ability to absorb IR radiation and convert it into heat such as, for example, cyanine.

A particularly useful family of absorbers is that characterised by the following skeleton: 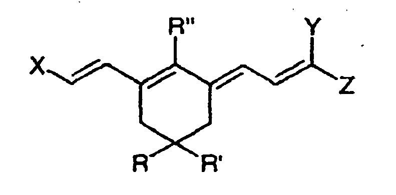 where X, Y, Z, R, R' and R" may have many meanings.

Typical examples of such meanings are: a single or condensed heterocyclic ring for X, a single or condensed heterocyclic ring for Z and Y together with the carbon atom to which they are bound, hydrogen, C₁₋₃ alkyl, SO₃⁻ or COO- for R and R' independently of each other and H or Cl for R".

Particular examples of the said heterocyclic rings are:

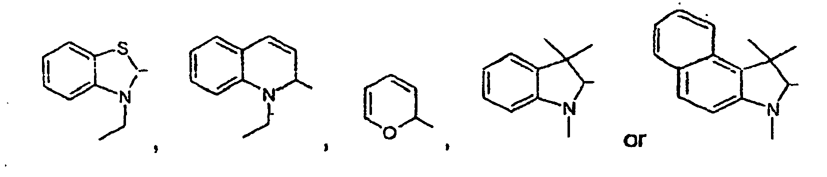

The presumed structures of some specific absorbers are:

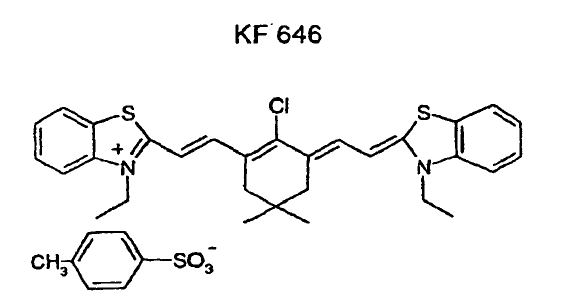

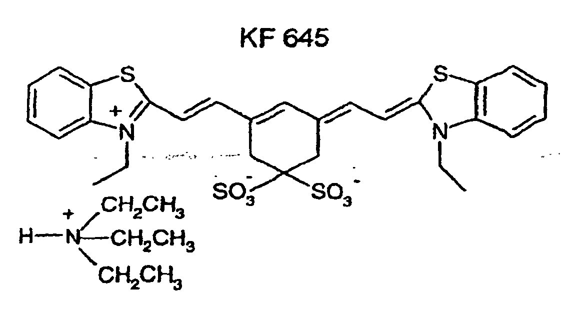

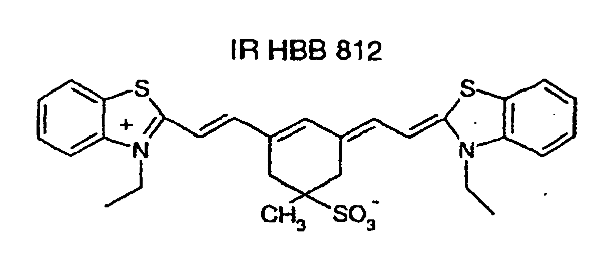

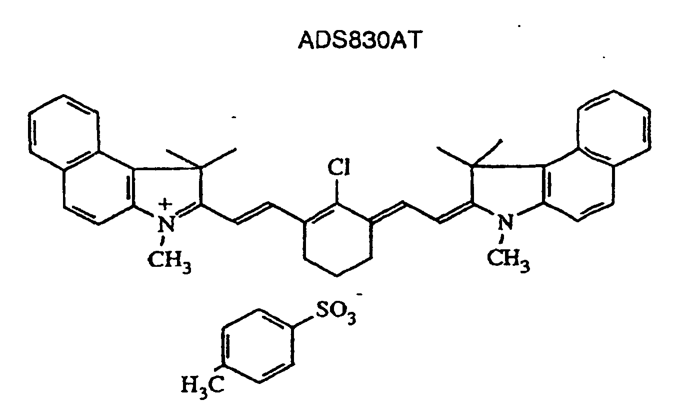

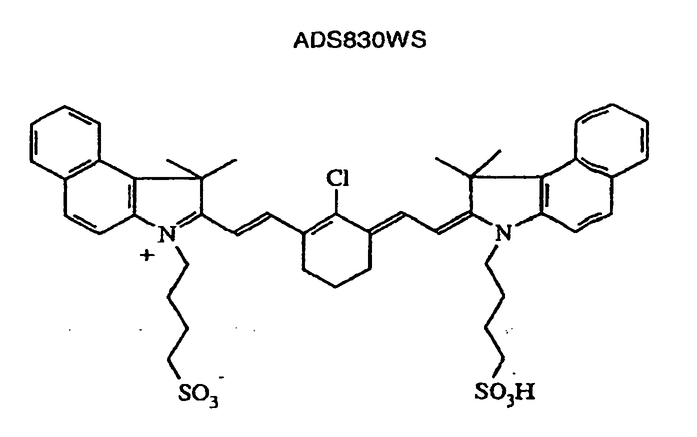

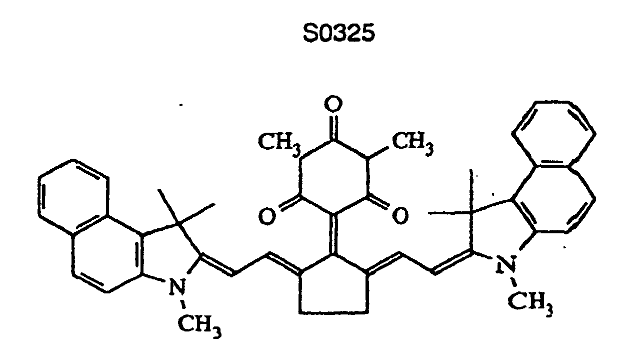

Typical examples of commercial products are the absorbers KF 646, KF 645, KF 810, KF 1003, KF 1002. IR HBB 812 and KF 818 from the Honeywell company (Seelze, Germany), the absorbers ADS830AT and ADS830WS from the American Dye Source Company (Varennes, Quebec, Canada), the absorbers PROJET 830 NP and PROJECT 825 LDI from the Avecia Company (Manchester, England) and the absorber SO325 from the FEW Chemicals GmbH company (Wolfen, Germany).

Preferably, the quantity of the said IR absorber in the composition according to this invention is from 1% to 12% by weight Even more preferably the said quantity will be from 5% to 10% by weight

Advantageously the triazine compound according to this invention will have the structural formula:

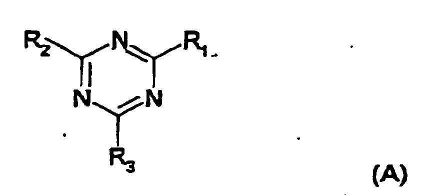

Where at least one of the substituents R1, R2 and R3 is NR'R" and the others are H or NR'R" and at least one of the substitutents R' and R" is -CH₂-O-Alk_{1-4C} and the other R' and R", which are the same or different from each other, are H or -CH₂-O-Alk_{1-4C}.

Preferably two of these substituents R1, R2 and R3 are NR'R". Even more preferably all three substituents R1, R2 and R3 are NR'R".

As extensively described in the literature, the triazine compound of formula (A) is generally prepared by the condensation of an amino triazine of formula A in which all the substituents R' and R" are H, with a suitable quantity of formaldehyde and subsequent reaction of the methylol (-CH₂OH) groups formed with an Alk_{1-4C} -OH alcohol in order to yield -CH₂-O-Alk_{1-4C} groups.

The preferred commercial triazine compounds according to this invention are:
Maprenal™ VMF 3935 [tri-(methoxy/n-butoxy) methyl melamine (60/40)] from the Vianova Resins company,
Maprenal™ MF 927 [tri-(methoxy/n-butoxy) methyl melamine (90/10)] from the Vianova Resins company,
Resimene™ CE 7103 [hexa-(methoxy/n-butoxy) methyl melamine (90110)] from the company Solutia S.p.A.,
Maprenal™ VMF 3924 [tetra-(methoxy/n-butoxy) methyl melamine (50/50)] from the Vianova Resins company,
Resimene™ CE 6517 [tetra-(methoxy/n-butoxy) methyl melamine (70/30)] from the company Solutia S.p.A.

Preferably the quantity of the said triazine compound in the composition according to this invention is from 10 to 30% by weight. Even more preferably this quantity is from 15 to 25% by weight.

Advantageously the novolak resin present in the composition according to this invention has a weight average molecular weight of between 2,000 and 14,000.

Preferably the composition according to this invention comprises at least two novolak resins: a first having a weight average molecular weight of between 3000 and 5000 and a second having a weight average molecular weight of between 6000 and 11000.

Typically the quantity of novolak resin in the composition according to this invention is from 1 to 20% by weight. Even more preferably the said quantity is from 5 to 20% by weight.

Typical examples of commercial novolak resins which are useful in the composition according to this invention are:
LB 6564 (weight average molecular weight 6,000-10,000) from the Bakelite company (Germany),
LB 744 (weight average molecular weight 8,000-13,000) from the Bakelite company (Germany),
R 7100 (weight average molecular weight 9,500-10,500) from the Rohner company (Switzerland), obtained by removing monomers from resin LB 744,
PN 430 (weight average molecular weight 5,000 - 9,500) from the Clariant company (Germany), and
PN 320 (weight average molecular weight 3,000 - 5,000) from the Clariant company (Germany).

An important feature of the composition according to this invention is that its hydrophilic regions (non-printing areas) are not soluble in alkali or in the wash water, but also have a high affinity for the wash water.

In a second aspect this invention relates to a negative lithographic plate comprising a substrate coated with a composition according to this invention as described above.

In a third aspect this invention relates to a method for obtaining a negative image on a substrate coated with a composition which is first hydrophilic and then lipophilic after exposure to heat, without the removal of material, the said method being characterised in that the said negative image is obtained by applying a small quantity of energy to the said compositions.

This invention is further described by the following Examples and Tests which are only of an illustrative nature and should not be regarded as limiting the invention.

### EXPERIMENTAL PART

### Examples 1-15

### Compositions

7 g of each of the fifteen mixtures of components indicated in Tables 1-4 were dissolved at ambient temperature (approximately 25°C) in 93 g of a 90:10 mixture (by weight) of N-methylpyrrolidinone: methoxypropanol, stirring mechanically until complete dissolution.

The mixture was then filtered under vacuum on Perfected® model 2 paper (⌀=15 cm) from the Superfiltro company, Milan, Italy.

**Table 1**

| Composition no. | 1 | 2 | 3 | 4 |
|---|---|---|---|---|
| Component | % (w/w) | % (w/w) | % (w/w) | % (w/w) |
| Gantrez™ S 97 BF | 54.32 | | | 59.26 |
| Gantrez™ S 95 BF | | 54.32 | | |
| Gantrez™ S 96 BF | | | 54.32 | |
| Maprenal™ VMF 3935 [70% solution (w/w) in butyl alcohol) | 19.75 | 19.75 | 19.75 | 19.75 |
| R 7100 | 18.52 | 18.52 | 18.52 | 13.58 |
| ADS 830AT | 7.408 | 7.408 | 7.408 | 7.408 |

**Table 2**

| Composition no. | 5 | 6 | 7 | 8 |
|---|---|---|---|---|
| Component | % (w/w) | % (w/w) | % (w/w) | % (w/w) |
| Gantrez™ S 97 BF | 57.28 | 66.17 | 57.28 | 57.28 |
| Maprenal™ VMF 3935/70 B | 23.7 | 18.76 | 23.7 | 23.7 |
| R 7100 | 11.61 | 7.66 | 11.61 | 11.61 |
| ADS 830AT | 7.408 | 7.408 | 5.408 | |
| S0325 | | | 2 | 7.408 |

**Table 3**

| Composition no. | 9 | 10 | 11 | 12 |
|---|---|---|---|---|
| Component | % (w/w) | % (w/w) | % (w/w) | % (w/w) |
| Gantrez™ S 97 BF | 64.2 | 64.2 | 64.2 | 58.27 |
| Maprenal™ VMF 3935/70 B | 19.75 | | | 21.73 |
| Maprenal™ MF 904 | | 19.75 | | |
| Maprenal™ MF 927 | | | 19.75 | |
| R 7100 | 8.64 | 8.64 | 8.64 | 12.59 |
| ADS 830AT | 7.408 | 7.408 | 7.408 | 7.408 |

**Table 4**

| Composition no. | 13 | 14 | 15 |
|---|---|---|---|
| Component | % (w/w) | % (w/w) | % (w/w) |
| Gantrez™ S 97 BF | 69.17 | 69.17 | 69.17 |
| Maprenal™ VMF 3935/70 B | 17.26 | 17.26 | 17.26 |
| R 7100 | 6.16 | | |
| LB 6564 | | 6.16 | |
| PN 430 | | | 6.16 |
| ADS 830AT | 7.408 | 7.408 | 7.408 |

### Examples 16-46

### Lithographic plates

The compositions in Examples 1-15 above were spread on to
A) degreased aluminium, and
B) aluminium electrochemically grained , subjected to anodic oxidation and treated with a solution of polyvinyl phosphonic acid.

The plates coated in this way were dried in a hot-air furnace (PID System M80-VF from the company MPM Instruments s.r.l., Bemareggio, Milan, Italy) at 85°C for 8 minutes. The weight of the photosensitive coating lay between 2.5 and 4.0 g/m².

The plates so obtained are listed in Table 5 below.

**Table 5**

| Composition | Substrate | Plate Code |
|---|---|---|
| 1 | A | A1 |
| 1 | B | B1 |
| 2 | A | A2 |
| 2 | B | B2 |
| 3 | A | A3 |
| 3 | B | B3 |
| 4 | A | A4 |
| 4 | B | B4 |
| 5 | A | A5 |
| 5 | B | B5 |
| 6 | A | A6 |
| 6 | B | B6 |
| 7 | A | A7 |
| 7 | B | B7 |
| 8 | A | A8 |
| 8 | B | B8 |
| 9 | A | A9 |
| 9 | B | B9 |
| 10 | A | A10 |
| 10 | B | B10 |
| 11 | A | A11 |
| 11 | B | B11 |
| 12 | A | A12 |
| 12 | B | B12 |
| 13 | A | A13 |
| 13 | B | B13 |
| 14 | A | A14 |
| 14 | B | B14 |
| 15 | A | A15 |
| 15 | B | B15 |

After being allowed to stand for at least 24 hours, the plates were subjected to the following Tests.

### TESTS

### Properties

The lithographic plates in Table 5 were exposed to IR radiation having a wavelength of 830 nm (Platesetter LOTEM™ 800 V from the Scitex Co., Herzlia, Israel) at 2540 dpi. Exposure was carried out by projecting a UGRA/FOGRA PostScript Control Strip digital scale at an intensity varying from 180 mW to 300 mW and at a constant drum speed (700 rpm), corresponding to energy levels substantially between 150 mJ/cm² and 250 mJ/cm².

After exposure the plates showed an advantageous change of colour in the exposed regions in comparison with the unexposed regions thus making it possible even at that stage to assess the quality of the negative image obtained.

The plates were then subjected to printing tests using a Speedmaster™ printing machine from the Heidelberg Company equipped with wash water containing 2% of isopropyl alcohol and 2% of the wash additive JOLLY FOUNT™ LAB 55 from Lastra S.p.a. and ink of the HARD CLIPPER BLACK OFFSET™ type from the Mander-Kidd company, England. The printing speed was 5000 sheets/hour and the paper was of the Patinato type weighing 80 g/m².

Sensitivity was measured for each plate by determining the exposure conditions required to obtain a print which faithfully reproduced the UGRA/FOGRA PostScript Control Strip digital scale.

The results of these measurements are shown in Table 6 below.

The following parameters were determined at the same time:
- number of sheets required to achieve cleaning of the background,
- number of sheets required in order to reach the correct ink density in the printing zone, and
- maximum number of copies which could be printed (strength of the printing regions).

In a certain number of cases the number of sheets required to achieve cleaning of the background and to achieve the correct ink density in the printing zone were only a few units (5-10).

The number of copies printed was 40,000 copies or more for a certain number of plates.

**Table 6**

| Plate | Sensitivity |
|---|---|
| A1 | 300 mW; 700 rpm |
| B1 | 300 mW; 700 rpm |
| A2 | 300 mW; 700 rpm |
| B2 | 300 mW; 700 rpm |
| A3 | 300 mW; 700 rpm |
| B3 | 300 mW; 700 rpm |
| A4 | 260 mW; 700 rpm |
| B4 | 240 mW; 700 rpm |
| A5 | 280 mW; 700 rpm |
| B5 | 260 mW; 700 rpm |
| A6 | 260 mW; 700 rpm |
| B6 | 240 mW; 700 rpm |
| A7 | 280 mW; 700 rpm |
| B7 | 260 mW; 700 rpm |
| A8 | 280 mW; 700 rpm |
| B8 | 260 mW; 700 rpm |
| A9 | 260 mW; 700 rpm |
| B9 | 240 mW; 700 rpm |
| A10 | 280 mW; 700 rpm |
| B10 | 260 mW; 700 rpm |
| A11 | 260 mW; 700 rpm |
| B11 | 240 mW; 700 rpm |
| A12 | 260 mW; 700 rpm |
| B12 | 240 mW; 700 rpm |
| A13 | 280 mW; 700 rpm |
| B13 | 260 mW; 700 rpm |
| A14 | 300 mW; 700 rpm |
| B14 | 300 mW; 700 rpm |
| A15 | 300 mW; 700 rpm |
| B15 | 300 mW; 700 rpm |

### COMPARISON EXAMPLE 1

The composition in Example 1 in EP-A-0 924 065 was prepared.

7.73 g of the said composition were dissolved in 90 g of a mixture comprising tetrahydrofuran 44% (w/w), 1-methoxy-2-propanol 34% (w/w) and 2-butanone 22% (w/w).

The mixture so obtained was used to coat aluminium plates which had been electrochemically grained, subjected to anodic oxidation and treated with a solution of polyvinyl sulphonic acid. The plates coated in this way were then dried in a furnace as described for Examples 16-46.

In three successive preparations the quantity of dry coating applied to the plate was 0.9 g/m², 1.59 g/m² and 2.57 g/m².

The plates obtained in this way were exposed to heat as indicated in Example 1 of EP-A-0 924 065 and were then subjected to printing tests as described in the "Tests" above.

In no case was it possible to obtain acceptable cleaning of the background until approximately 1000 pages had been printed.

## Claims

1. Heat-sensitive composition which forms an image without the removal of material, which does not require any developing treatment after the stage of exposure to heat and comprises:
a) a switchable polymer, and
b) an IR absorber,
**characterised in that** it also comprises:
c) a triazine compound which is a compound obtained by condensation of formaldehyde with an aminotriazine and subsequent reaction of the thus obtained product with an aliphatic alcohol having 1-4 C atoms and
d) a novolak resin.

2. Composition according to claim 1, **characterised in that** the said switchable polymer has attached hydrophilic groups and becomes lipophilic through the effect of IR radiation.

3. Composition according to claim 2, **characterised in that** the said attached hydrophilic groups are carboxyl groups.

4. Composition according to claim 1, **characterised in that** the said switchable polymer is a compound obtained by the acid hydrolysis of a copolymer of methyl vinyl ether and maleic anhydride.

5. Composition according to claim 1, **characterised in that** the quantity of the said switchable polymer is from 50% to 75% by weight.

6. Composition according to claim 5, **characterised in that** the quantity of the said switchable polymer is from 55% to 70% by weight

7. Composition according to any one of claims 1 to 6, **characterised in that** the IR absorber is a cyanine dye.

8. Composition according to any one of claims 1 to 7, **characterised in that** the IR absorber has the following formula

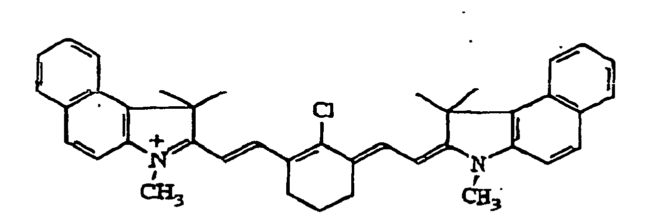

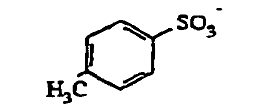

9. Composition according to any one of claims 1 to 8, **characterised in that** the quantity of the said IR absorber is from 1% to 12% by weight.

10. Composition according to any one of claims 1 to 8,
**characterised in that** the quantity of the said IR absorber is from 5% to 10% by weight.

11. Composition according to any one of claims 1 to 10,
**characterised in that** the triazine compound has the structural formula: 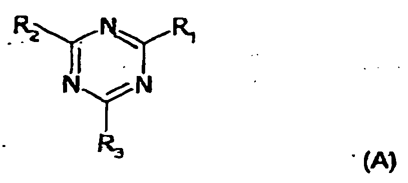 where at least one of the substituents R1. R2 and R3 is NR'R" and the others are H or NR'R'' and at least one of the substituents R' and R" is -CH₂-O-Alk_{1-4C} and the others R' and R", which are the same or different from each other, are H or -CH₂-O-Alk_{1-4C}.

12. Composition according to claim 11, **characterised in that** two of the substituents R¹, R2 and R3 are NR'R".

13. Composition according to claim 11, **characterised in that** all three substituents R1, R2 and R3 are NR'R".

14. Composition according to claim 13, **characterised in that** the three R' substituents are H, two of the R" substituents are - CH₂-O-CH₃ and the third R" substituent is -CH₂-O-C₄H₉.

15. Composition according to claim 13, **characterised in that** the three R' substituents are -CH₂-O-CH₃ and the three R" substituents are -CH₂-O-CH₃.

16. Composition according to claim 13, **characterised in that** the three R' substituents are -CH₂-O-CH₃ and the three R° substituents are -CH₂-O-C₄H₉.

17. Composition according to claim 12, **characterised in that** the two R' substituents are -CH₂-O-CH₃ and the two R° substituents are -CH₂-O-C₄H₉.

18. Composition according to any one of claims 1 to 17, **characterised in that** the quantity of the said triazine compound is from 10 to 30% by weight.

19. Composition according to any one of claims 1 to 17, **characterised in that** the quantity of the said triazine compound is from 15 to 25% by weight.

20. Composition according to any one of claims 1 to 19, **characterised in that** the said novolak resin has a weight average molecular weight of between 2,000 and 14,000.

21. Composition according to any one of claims 1 to 20, **characterised in that** the said composition comprises at least two novolak resins, a first having a weight average molecular weight of between 3,000 and 5,000 and a second having a weight average molecular weight of between 6,000 and 11,000.

22. Composition according to any one of claims 1 to 21, **characterised in that** the total quantity of novolak resin is from 1 to 20% by weight.

23. Composition according to any one of claims 1 to 21, **characterised in that** the total quantity of novolak resin is from 5 to 20% by weight.

24. Negative lithographic plate comprising a substrate coated with a composition according to any one of the foregoing claims from 1 to 23.

## Patentansprüche

1. Eine wärmeempfindliche Zusammensetzung, die ohne Entfernung von Material ein Bild erzeugt, keine Entwicklungsbehandlung nach der Erwärmung erfordert und
a) ein schaltbares Polymer und
b) einen IR-Absorber enthält,
**dadurch gekennzeichnet, dass** die Zusammensetzung ferner
c) eine Triazinverbindung, die eine durch Kondensation von Formaldehyd mit einem Amintriazin und anschließende Reaktion des so erhaltenen Produkts mit einem alifatischen Alkohol mit 1 bis 4 Kohlenstoffatomen erhaltene Verbindung ist, und
d) ein Novolakharz enthält.

2. Zusammensetzung nach Anspruch 1, **dadurch gekennzeichnet, dass** das schaltbare Polymer gebundene hydrophile Gruppen enthält und unter der Einwirkung von Infrarotstrahlung lipophil gemacht wird.

3. Zusammensetzung nach Anspruch 2, **dadurch gekennzeichnet, dass** die gebundenen hydrophilen Gruppen Carboxylgruppen sind.

4. Zusammensetzung nach Anspruch 1, **dadurch gekennzeichnet, dass** das schaltbare Polymer eine durch Säurehydrolyse eines Copolymers aus Methylvinylether und Maleinsäureanhydrid erhaltene Verbindung ist.

5. Zusammensetzung nach Anspruch 1, **dadurch gekennzeichnet, dass** die Menge schaltbares Polymer zwischen 50 Gew.-% und 75 Gew.-% liegt.

6. Zusammensetzung nach Anspruch 5, **dadurch gekennzeichnet, dass** die Menge schaltbares Polymer zwischen 55 Gew.-% und 70 Gew.-% liegt.

7. Zusammensetzung nach einem der Ansprüche 1 bis 6, **dadurch gekennzeichnet, dass** der IR-Absorber ein Cyaninfarbstoff ist.

8. Zusammensetzung nach einem der Ansprüche 1 bis 7, **dadurch gekennzeichnet, dass** der IR-Absorber folgender Formel entspricht :

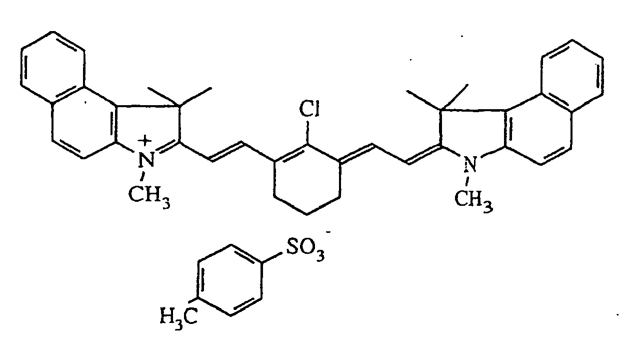

9. Zusammensetzung nach einem der Ansprüche 1 bis 8, **dadurch gekennzeichnet, dass** die Menge IR-Absorber zwischen 1 Gew.-% und 12 Gew.-% liegt.

10. Zusammensetzung nach einem der Ansprüche 1 bis 8, **dadurch gekennzeichnet, dass** die Menge IR-Absorber zwischen 5 Gew.-% und 10 Gew.-% liegt.

11. Zusammensetzung nach einem der Ansprüche 1 bis 10, **dadurch gekennzeichnet, dass** die Triazinverbindung folgender Strukturformel entspricht : 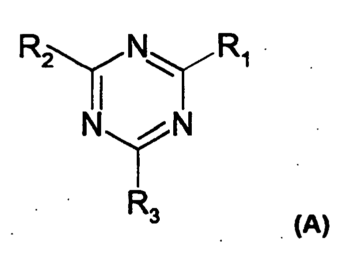 in der zumindest einer der Substituenten R₁, R₂ und R₃ NR'R" bedeutet und die anderen Substituenten H oder NR'R" bedeuten und zumindest einer der Substituenten R' und R" -CH₂-O-Alk_{1-4C} bedeutet und die anderen Substituenten R' und R", die gleich oder verschieden sind, H oder -CH₂-O-Alk_{1-4C} bedeuten.

12. Zusammensetzung nach Anspruch 11, **dadurch gekennzeichnet, dass** zwei der Substituenten R₁, R₂ und R₃ NR'R" bedeuten.

13. Zusammensetzung nach Anspruch 11, **dadurch gekennzeichnet, dass** alle drei Substituenten R₁, R₂ und R₃ NR'R" bedeuten.

14. Zusammensetzung nach Anspruch 13, **dadurch gekennzeichnet, dass** die drei R'-Substituenten H bedeuten, zwei der R"-Substituenten -CH₂-O-CH₃ bedeuten und der dritte R"-Substituent CH₂-O-C₄H₉ bedeutet.

15. Zusammensetzung nach Anspruch 13, **dadurch gekennzeichnet, dass** die drei R'-Substituenten -CH₂-O-CH₃ bedeuten und die drei R"-Substituenten -CH₂-O-CH₃ bedeuten.

16. Zusammensetzung nach Anspruch 13, **dadurch gekennzeichnet, dass** die drei R'-Substituenten -CH₂-O-CH₃ bedeuten und die drei R"-Substituenten -CH₂-O-C₄H₉ bedeuten.

17. Zusammensetzung nach Anspruch 12, **dadurch gekennzeichnet, dass** die zwei R'-Substituenten -CH₂-O-CH₃ bedeuten und die zwei R"-Substituenten -CH₂-O-C₄H₉ bedeuten.

18. Zusammensetzung nach einem der Ansprüche 1 bis 17, **dadurch gekennzeichnet, dass** die Menge Triazinverbindung zwischen 10 Gew.-% und 30 Gew.-% liegt.

19. Zusammensetzung nach einem der Ansprüche 1 bis 17, **dadurch gekennzeichnet, dass** die Menge Triazinverbindung zwischen 15 Gew.-% und 25 Gew.-% liegt.

20. Zusammensetzung nach einem der Ansprüche 1 bis 19, **dadurch gekennzeichnet, dass** das Novolakharz ein Gewichtsmittel des Molekulargewichts zwischen 2.000 und 14.000 aufweist.

21. Zusammensetzung nach einem der Ansprüche 1 bis 20, **dadurch gekennzeichnet, dass** die Zusammensetzung zumindest zwei Novolakharze enthält, wobei ein erstes Novolakharz ein Gewichtsmittel des Molekulargewichts zwischen 3.000 und 5.000 und ein zweites Novolakharz ein Gewichtsmittel des Molekulargewichts zwischen 6.000 und 11.000 aufweist.

22. Zusammensetzung nach einem der Ansprüche 1 bis 21, **dadurch gekennzeichnet, dass** die Gesamtmenge Novolakharz zwischen 1 Gew.-% und 20 Gew.-% liegt.

23. Zusammensetzung nach einem der Ansprüche 1 bis 21, **dadurch gekennzeichnet, dass** die Gesamtmenge Novolakharz zwischen 5 Gew.-% und 20 Gew.-% liegt.

24. Negativarbeitende lithografische Druckplatte mit einem Substrat, das mit einer Zusammensetzung nach irgendwelchem der vorstehenden Ansprüche 1 bis 23 beschichtet ist.

## Revendications

1. Composition thermosensible qui forme une image en l'absence de retrait de matériau, qui ne requiert aucun traitement de développement après l'étape d'exposition à la chaleur et qui comprend :
a) un polymère commutable, et
b) un absorbeur du rayonnement infrarouge,
**caractérisée en ce qu'**elle comprend également :
c) un composé de triazine, à savoir un composé que l'on obtient par condensation de formaldéhyde avec une aminotriazine et par réaction ultérieure du produit ainsi obtenu avec un alcool aliphatique contenant de 1 à 4 atomes de carbone, et
d) une résine novolaque.

2. Composition selon la revendication 1, **caractérisée en ce que** ledit polymère commutable possède des groupes hydrophiles qui y sont associés et devient lipophile sous l'effet du rayonnement infrarouge.

3. Composition selon la revendication 2, **caractérisée en ce que** lesdits groupes hydrophiles associés sont des groupes carboxyle.

4. Composition selon la revendication 1, **caractérisée en ce que** ledit polymère commutable est un composé que l'on obtient par l'hydrolyse acide d'un copolymère d'éther méthylvinylique et d'anhydride maléique.

5. Composition selon la revendication 1, **caractérisée en ce que** la quantité dudit polymère commutable s'élève de 50 % à 75 % en poids.

6. Composition selon la revendication 5, **caractérisée en ce que** la quantité dudit polymère commutable s'élève de 55 % à 70 % en poids.

7. Composition selon l'une quelconque des revendications 1 à 6, **caractérisée en ce que** l'absorbeur du rayonnement infrarouge est un colorant de cyanine.

8. Composition selon l'une quelconque des revendications 1 à 7, **caractérisée en ce que** l'absorbeur du rayonnement infrarouge répond à la formule suivante :

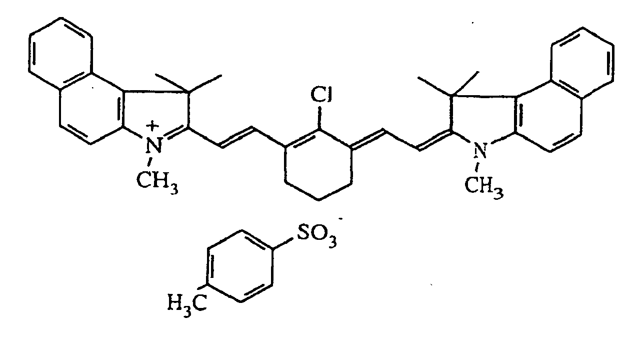

9. Composition selon l'une quelconque des revendications 1 à 8, **caractérisée en ce que** la quantité dudit absorbeur du rayonnement infrarouge s'élève de 1 % à 12 % en poids.

10. Composition selon l'une quelconque des revendications 1 à 8, **caractérisée en ce que** la quantité dudit absorbeur du rayonnement infrarouge s'élève de 5 % à 10 % en poids.

11. Composition selon l'une quelconque des revendications 1 à 10, **caractérisée en ce que** le composé de triazine répond à la formule développée : 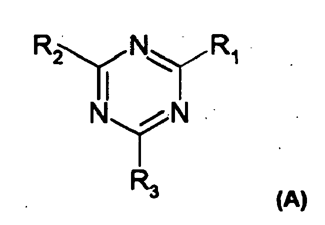 dans laquelle au moins un des substituants R1, R2 et R3 représente un groupe NR'R", les autres représentant un atome d'hydrogène ou un groupe NR'R", au moins un des substituants R' et R" représentant un groupe -CH₂-O-alkyle en C₁-C₄, les autres substituants R' et R", qui sont identiques ou différents l'un de l'autre, représentant un atome d'hydrogène ou un groupe -CH₂-O-alkyle en C₁-C₄.

12. Composition selon la revendication 11, **caractérisée en ce que** deux des substituants R1, R2 et R3 représentent un groupe NR'R".

13. Composition selon la revendication 11, **caractérisée en ce que** les trois substituants R1, R2 et R3 représentent un groupe NR'R".

14. Composition selon la revendication 13, **caractérisée en ce que** les trois substituants R' représentent un atome d'hydrogène, deux des substituants R" représentent un groupe -CH₂-O-CH₃ et le troisième substituant R" représente un groupe -CH₂-O-C₄H₉.

15. Composition selon la revendication 13, **caractérisée en ce que** les trois substituants R' représentent un groupe -CH₂-O-CH₃ et les trois substituants R" représentent un groupe -CH₂-O-CH₃.

16. Composition selon la revendication 13, **caractérisée en ce que** les trois substituants R' représentent un groupe -CH₂-O-CH₃ et les trois substituants R" représentent un groupe -CH₂-O-C₄H₉.

17. Composition selon la revendication 12, **caractérisée en ce que** les deux substituants R' représentent un groupe -CH₂-O-CH₃ et les deux substituants R" représentent un groupe -CH₂-O-C₄H₉.

18. Composition selon l'une quelconque des revendications 1 à 17, **caractérisée en ce que** la quantité dudit composé de triazine s'élève de 10 à 30 % en poids.

19. Composition selon l'une quelconque des revendications 1 à 17, **caractérisée en ce que** la quantité dudit composé de triazine s'élève de 15 à 25 % en poids.

20. Composition selon l'une quelconque des revendications 1 à 19, **caractérisée en ce que** ladite résine novolaque possède un poids moléculaire moyen en poids entre 2.000 et 14.000.

21. Composition selon l'une quelconque des revendications 1 à 20, **caractérisée en ce que** ladite composition comprend au moins deux résines novolaque, une première possédant un poids moléculaire moyen en poids entre 3.000 et 5.000 et une deuxième possédant un poids moléculaire moyen en poids entre 6.000 et 11.000.

22. Composition selon l'une quelconque des revendications 1 à 21, **caractérisée en ce que** la quantité totale de la résine novolaque s'élève de 1 à 20 % en poids.

23. Composition selon l'une quelconque des revendications 1 à 21, **caractérisée en ce que** la quantité totale de la résine novolaque s'élève de 5 à 20 en poids.

24. Cliché lithographique à traitement négatif comprenant un substrat sur lequel on coule une composition selon l'une quelconque des revendications précédentes 1 à 23.
